# FASCICULE DE BREVET EUROPEEN

(11) **EP 2 910 439 B1**
(45) Date de publication et mention de la délivrance du brevet: **14.08.2019**
(21) Numéro de dépôt: 15154315.4
(22) Date de dépôt: 09.02.2015
(51) Int. Cl.: B60S 1/38

(54) **Dispositif chauffant pour balai d'essuie-glace d'un vehicule, balai d'essuie-glace le comportant, et procédé d'assemblage d'un tel balai d'essuie-glace**
Heizvorrichtung für Scheibenwischer eines Fahrzeugs, Scheibenwischer, der diese Vorrichtung umfasst, und Verfahren zum Zusammenbau eines solchen Scheibenwischers
Heating device for windscreen-wiper blade of a vehicle, windscreen-wiper blade comprising same, and method for assembling such a windscreen-wiper blade

(30) Priorité: 24.02.2014 FR 1451451
(43) Date de publication de la demande: 26.08.2015
(73) Titulaire: Valeo Systèmes d'Essuyage, 78322 Le Mesnil Saint Denis (FR)
(72) Inventeur: Caillot, Gérald, 78720 CERNAY LA VILLE (FR); Jarasson, Jean-Michel, 78321 LE MESNIL SAINT DENIS (FR); Izabel, Vincent, 91380 CHILLY MAZARIN (FR)
(74) Mandataire: Callu-Danseux, Violaine

(56) Documents cités:
- WO-A1-2009/118286
- WO-A1-2011/003613
- WO-A1-2012/089552
- DE-A1- 19 936 277
- US-A1- 2012 005 856

## Description

La présente invention concerne un dispositif chauffant pour balai d'essuie-glace d'un véhicule et un balai d'essuie-glace le comportant. Il concerne également un procédé d'assemblage d'un tel balai d'essuie-glace.

Le dispositif chauffant dans ce genre de balai d'essuie-glace comprend un élément chauffant intégré dans le corps du balai d'essuie-glace en s'étendant sur sensiblement toute la longueur de celui-ci. Grâce à la présence de cet élément chauffant, il est possible de faire fondre de la glace ou de la neige qui lors de la période froide peut autrement se former ou s'agglutiner sur le balai d'essuie-glace et qui alors nuit à son bon fonctionnement. Cela peut être encore plus gênant lorsque le balai d'essuie-glace est pourvu d'une rampe de distribution d'un liquide de lavage qui dans le cas où il gèle, en particulier au niveau des trous de distribution, empêche le liquide de sortir et peut d'une manière générale rendre l'ensemble du balai d'essuie-glace trop rigide.

Le dispositif chauffant du balai d'essuie-glace peut comprendre un ou plusieurs fils résistifs associés à un des éléments constitutifs du balai d'essuie-glace. Le ou les fils résistifs s'étendent en général tout au long d'un de ces éléments constitutifs.

On connaît également un tel dispositif chauffant comprenant un film résistif incorporé dans le balai d'essuie-glace. Ce balai d'essuie-glace est du type plat, souvent désigné comme un balai d'essuie-glace souple ou balai d'essuie-glace plat.

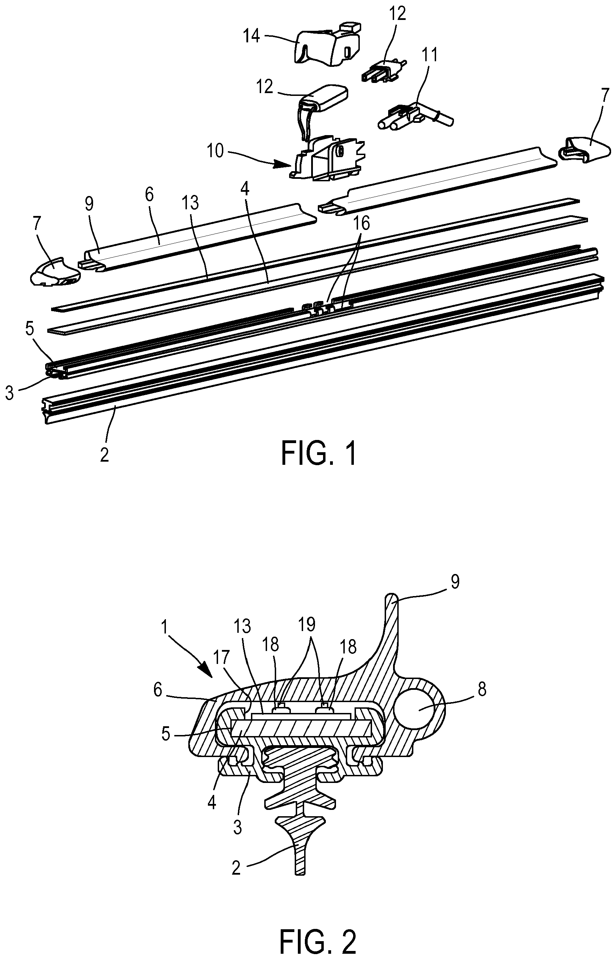

Les éléments constitutifs de ce balai d'essuie-glace connu sont montrés à la figure 1 et comprennent, de bas en haut, une lame de raclage 2, en général en élastomère, fixée à un élément de support allongé 3, en général en un matériau plastique semi-rigide, un élément d'axe principal longitudinal 4 formant une vertèbre disposée dans un logement longitudinal 5 de l'élément de support 3, et un élément de couverture 6 fixé sur l'élément de support 3 par encliquetage. Ces éléments constitutifs présentent sensiblement la même longueur et lors de l'assemblage du balai d'essuie-glace, un capuchon embout 7 est fixé à chaque extrémité de celui-ci.

Une coupe d'un tel balai d'essuie-glace assemblé est illustrée à la figure 2. L'élément de couverture 6 constitue un accessoire qui dans cet exemple comprend en outre sur une partie de sa longueur une rampe de projection 8 d'un liquide de lavage. La rampe 8 est pourvue de trous de projection (non représentés). Cet accessoire comporte avantageusement un déflecteur aérodynamique 9 destiné à solliciter avec plus de vigueur la lame de raclage 2 contre une vitre de véhicule (non montrée). L'élément de couverture 6 peut en variante comprendre deux rampes de projection, une le long de chaque côté de l'élément de couverture.

L'élément de couverture 6 du balai d'essuie-glace 1 est en deux parties de sensiblement la même longueur et reliées l'une à l'autre par l'intermédiaire d'un connecteur mécanique 10 qui abrite un connecteur hydraulique 11 pour le liquide de lavage, ainsi qu'un connecteur électrique 12 relié à un élément chauffant 13 qui sous forme d'un film résistif est incorporé dans le balai d'essuie-glace.

Le connecteur mécanique 10 est fermé vers l'extérieur par une chape formant organe de liaison 14 le reliant à un bras d'actionnement (non représenté) par une articulation (non représentée). Un dispositif d'essuyage est ainsi formé par le balai d'essuie-glace 1, ce bras d'actionnement, et un moteur d'entraînement en oscillation (non représenté) de celui-ci.

L'élément de support 3 comporte dans une zone centrale deux découpes latérales 16 disposées en regard l'une de l'autre. Ces découpes sont destinées à la fixation par encliquetage du connecteur mécanique 10 sur le balai d'essuie-glace lors de son assemblage.

L'élément formant vertèbre 4 est généralement en métal et pourra ci-dessous être désignée sous le terme raccourci de « vertèbre » (« spline » en anglais). Cette vertèbre joue un rôle essentiel dans ce balai d'essuie-glace puisqu'elle assure à l'ensemble du balai d'essuie-glace la rigidité requise pour une bonne tenue mécanique pour bien répartir la force d'appui du balai d'essuie-glace contre une vitre tout en restant suffisamment souple pour s'adapter à la forme de la surface de la vitre qui en général présente une forme bombée.

Lorsqu'on soulève ce balai d'essuie-glace souple, il prend la forme d'un haricot de sorte que sa face inférieure soit concave et sa face supérieure par conséquent convexe.

Dans ce balai d'essuie-glace à dispositif chauffant, la vertèbre 4 a en outre pour fonction d'acheminer et de répartir la chaleur en provenance de l'élément chauffant 13 disposé sur sa face supérieure. Par conséquent, dans un balai d'essuie-glace à dispositif chauffant, il est important que la vertèbre soit en un matériau bon conducteur de chaleur de manière à faire activement partie du dispositif chauffant.

L'élément chauffant 13 est dans cet exemple d'un balai d'essuie-glace connu sous forme d'un film résistif fixé sur la face supérieure de l'élément formant vertèbre 4 disposée dans le logement 5 de l'élément de support 3. Le logement 5 est ouvert vers le haut sur toute sa longueur par une large fente longitudinale 17 dans laquelle ce film résistif s'étend. Par conséquent, les zones latérales de la face supérieure de la vertèbre ne sont pas couvertes par ce film résistif.

Des points de contact électrique 18 prévus sur le film résistif immédiatement en dessous du connecteur mécanique sont reliés au connecteur électrique 12 par l'intermédiaire de moyens de conduction électrique qui dans l'exemple illustré comporte des fils conducteurs 19 qui passent par la fente 17 du logement 5.

A la place des fils conducteurs 19, il est possible d'utiliser une grille de connexion (en anglais appelée « leadframe ») ou bien des patins de contact flexibles.

Le document WO 2012/089552 A1 montre un dispositif chauffant selon le préambule de la première revendication.

Un but de l'invention est de proposer un dispositif chauffant pour un balai d'essuie-glace du même genre dans lequel l'élément chauffant se trouve mieux protégé que dans le balai d'essuie-glace qui vient d'être décrit, alors que son emplacement est optimal pour la distribution de la chaleur vers la face inférieure de l'élément de support et vers la lame de raclage, tout en assurant de manière simple la connectivité de l'élément chauffant au connecteur électrique intégré dans le connecteur mécanique pour la liaison avec le bras d'actionnement.

Ce dernier point est particulièrement délicat à mettre en oeuvre, étant donné que la largeur de la vertèbre 4 est relativement limitée, de l'ordre de 8 à 10 mm, et il est souhaitable d'éviter de prévoir un trou relativement important dans l'âme de la vertèbre pour ne pas réduire la robustesse de la vertèbre et ne pas influencer sur la répartition des pressions lors du fonctionnement du balai d'essuyage.

Selon l'invention, l'élément chauffant est disposé de telle manière que les éléments dans le connecteur mécanique ne sont pas directement exposés à la chaleur émise par l'élément chauffant, tout en assurant une connectivité simple entre l'élément chauffant et le connecteur électrique qui est associé au connecteur mécanique.

Ainsi, le risque d'endommager les éléments dans le connecteur mécanique, y compris le connecteur électrique, par une chaleur excessive est réduit dans le cas où le dispositif chauffant est souvent sollicité.

Un objet de l'invention est un dispositif chauffant apte à être assemblé à un élément de support d'un balai d'essuie-glace, le dispositif chauffant comportant :
- au moins un élément d'axe principal longitudinal apte à être monté à l'intérieur d'un logement longitudinal de l'élément de support de manière à former une vertèbre, ledit logement étant ouvert au-dessus de ladite vertèbre par une fente longitudinale ;
- au moins un élément chauffant disposé sur l'élément formant vertèbre et relié par des moyens de conduction électrique à un connecteur électrique disposé sur une face dite supérieure de celui-ci ;
caractérisé en ce que l'élément chauffant est disposé sur une face dite inférieure de l'élément formant vertèbre, et en ce que lesdits moyens de conduction électrique passent de ladite face inférieure à ladite face supérieure en contournant l'élément formant vertèbre à l'une des extrémités de celui-ci.

Selon d'autres caractéristiques de l'invention :
- lesdits moyens de conduction électrique s'étendent le long de ladite fente, sur ladite face supérieure de l'élément formant vertèbre ;
- lesdits moyens de conduction électrique sont reliés à l'élément chauffant par l'intermédiaire de patins de contact disposés dans une zone d'extrémité sur ladite face inférieure de l'élément formant vertèbre ;
- ladite zone d'extrémité est centralement placée ;
- lesdits patins de contact sont noyés dans une résine assurant leur étanchéité ; et
- l'élément chauffant est un film résistif fixé sur ladite face inférieure de l'élément formant vertèbre et s'étendant jusqu'à proximité de l'extrémité de celui-ci à laquelle lesdits moyens de conduction électrique le contournent.

Un autre but de l'invention est de proposer un balai d'essuie-glace comprenant un tel dispositif chauffant.

Encore un autre but de l'invention est de procéder un procédé d'assemblage d'un tel balai d'essuie-glace.

D'autres caractéristiques et avantages de l'invention ressortiront de la description non limitative qui va suivre de la réalisation de l'invention, en référence aux figures annexées dans lesquelles :
- la figure 1, déjà décrite, est une vue éclatée d'un balai d'essuie-glace appartenant à l'état de la technique ;
- la figure 2, déjà décrite, est une vue en coupe du balai d'essuie-glace de la figure 1, après assemblage, l'élément chauffant étant placé sur la face supérieure de la vertèbre ;
- la figure 3 est une vue partielle en perspective de la face inférieure d'une vertèbre montrant schématiquement un élément chauffant fixé à la face inférieure de celle-ci, ainsi que des patins de contact reliés à l'élément chauffant ;
- la figure 4 est une vue en perspective illustrant schématiquement l'insertion de la vertèbre portant l'élément chauffant dans un logement longitudinal d'un élément de support ;
- la figure 5 est une vue partielle en perspective montrant une extrémité de la vertèbre faisant saillie de l'élément de support et portant des patins de contact pour la connexion de l'élément chauffant à un connecteur électrique par des fils conducteurs ;
- la figure 6 est une vue partielle en perspective correspondant à la figure 5, dans laquelle les patins de contact ont été noyés dans une résine d'étanchéité ;
- la figure 7 montre schématiquement comment les fils conducteurs contournent l'extrémité de la vertèbre et sont disposés dans une fente de l'élément de support, sur la face supérieure de la vertèbre ;
- la figure 8 montre schématiquement les fils conducteurs disposés dans la fente de l'élément de support et le connecteur électrique mis en place sur un connecteur mécanique fixé sur l'élément de support dans lequel la vertèbre est insérée ;
- la figure 9 est une coupe transversale selon A-A de la figure 8 ;
- la figure 10 est une vue partielle en perspective de la partie centrale de la face inférieure d'une vertèbre montrant un élément chauffant disposé sur la face inférieure de la vertèbre qui comporte une encoche latérale longitudinalement décalée par rapport au centre et destinée à être utilisée pour le passage de fils conducteurs de la face inférieure à la face supérieure de la vertèbre ;
- la figure 11 est une vue partielle en perspective de la partie centrale de la vertèbre de la figure 10, montrant les fils conducteurs reliés d'une part à des patins de contact associés à l'élément chauffant et d'autre part à un connecteur électrique ;
- la figure 12 est une vue partielle en perspective correspondant à la figure 11, dans laquelle les patins de contact ont été noyés dans une résine d'étanchéité ;
- la figure 13 montre schématiquement les fils conducteurs s'étendant de la face inférieure à la face supérieure de la vertèbre en passant par une encoche latérale longitudinalement décalée de celui-ci ;
- la figure 14 est une vue en perspective illustrant schématiquement l'insertion de la vertèbre avec l'élément chauffant dans un logement longitudinale d'un élément de support ; et
- la figure 15 montre schématiquement les fils conducteurs passant par l'encoche décalée et reliés au connecteur électrique mis en place sur un connecteur mécanique fixé à l'élément de support.

Dans les figures, les éléments identiques ou équivalents à ceux déjà décrits en référence aux figures 1 à 2 porteront les mêmes signes de référence.

La différence essentielle par rapport au dispositif chauffant du balai d'essuie-glace déjà décrit en référence aux figures 1 et 2 réside dans le fait que l'élément chauffant 13 est disposé en dessous de l'élément formant vertèbre 4, et non pas au-dessus de celui-ci. Cela donne les avantages d'une répartition et d'une distribution améliorées vers le bas de la chaleur émise par l'élément chauffant tout en mettant le connecteur électrique 12 à l'abri d'un rayonnement de chaleur direct qui pourrait provoquer une surchauffe du connecteur lors d'une utilisation prolongée.

L'élément chauffant 13 est avantageusement formé par un film résistif qui se trouvera bien protégé dans le logement 5 prévu dans l'élément de support 3. Bien entendu, cela n'exclut pas l'utilisation de fils résistifs avec la même disposition à la place du film résistif.

Comme élément chauffant, il est également possible d'utiliser un revêtement résistif sous forme d'une peinture résistive ou autre revêtement déposé sur la vertèbre 4.

Or, avec cet emplacement avantageux de l'élément chauffant 13, il y a un problème de connectivité au niveau de la liaison électrique entre l'élément chauffant 13 qui se trouve en dessous de la vertèbre 4 et le connecteur électrique 12 qui se trouve au-dessus de celle-ci. Selon l'invention, ce problème de connectivité est résolu par le fait que les moyens de conduction électrique tels que les fils conducteurs 19, ou autres moyens de conduction électrique, reliant l'élément chauffant 13 au connecteur électrique 12, passent de la face inférieure à la face supérieure de la vertèbre 4 en contournant celle-ci par un de ses côtés, et en particulier à l'une de ses extrémités.

Grâce à ce contournement, on évite de fragiliser la vertèbre en y effectuant un trou, d'autant plus que la largeur de la vertèbre est relativement limitée, de l'ordre de 8 à 10 mm.

L'invention sera maintenant décrite en détail en référence aux dessins.

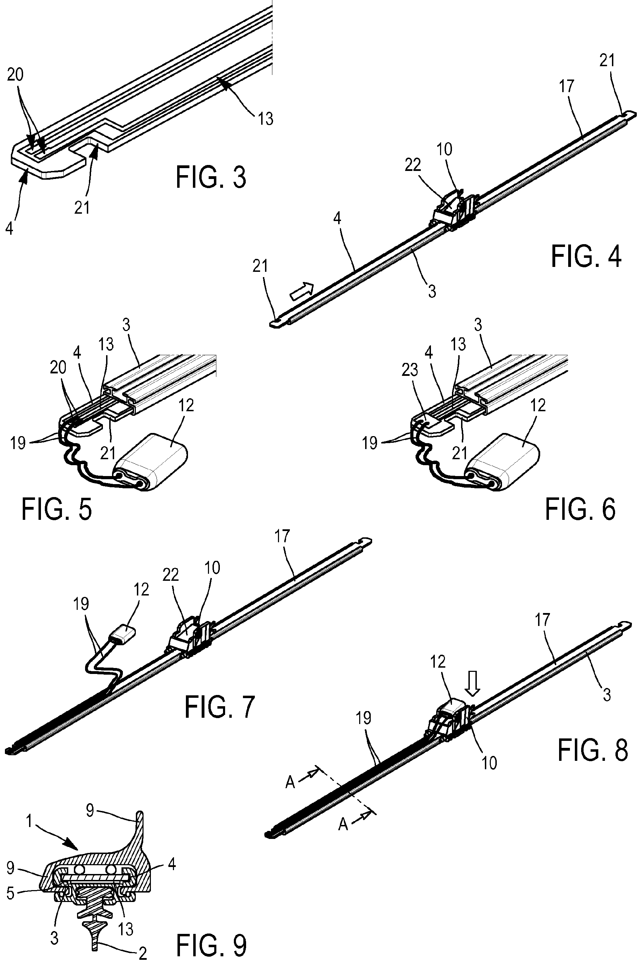

La figure 3 montre une partie de la face inférieure d'une vertèbre 4 sur laquelle un élément chauffant 13 sous forme d'un film résistif a été fixé. Ce film résistif s'étend avantageusement jusqu'à proximité de l'extrémité de vertèbre par laquelle les moyens de conduction électrique 19 le contournent.

Le film résistif 13 présente deux points de connexion sous forme de patins de contact 20 disposés parallèlement l'un à l'autre dans une zone d'extrémité de la face inférieure de la vertèbre. Cette zone d'extrémité est centralement placée à l'extrémité de la vertèbre 4.

En outre, la vertèbre 4 présente à ses extrémités une encoche latérale 21 pour la fixation d'un capuchon respectif 7 (voir figure 1) par encliquetage. Les patins de contact 20 sont dans l'exemple illustré disposés après l'encoche 21, mais ils peuvent en alternative être disposés avant celle-ci.

La figure 4 montre la vertèbre 4 de la figure 3 mise en place à l'intérieur du logement 5 de l'élément de support 3. Les extrémités de la vertèbre font saillie des extrémités de l'élément de support 3 pour présenter les encoches latérales 21 de fixation des capuchons 7.

Par ailleurs, un connecteur mécanique 10 est fixé par encliquetage au centre de l'élément de support 3. Ce connecteur mécanique 10 présente sur sa face supérieure un logement 22 de réception (voir figure 4) d'un connecteur électrique 12, comme cela est montré à la figure 8. Pour l'assemblage, l'élément formant vertèbre 4 est ensuite insérée dans le logement 5 de l'élément de support 3, puis elle passe au centre du balai 1 dans des formes en rail dans le connecteur mécanique 10 à l'aide d'encoches 24 qui viennent en correspondance de tétons (non représentés) prévus dans le connecteur mécanique 10. Le logement 22 sera par la suite fermé par la chape 14 montrée à la figure 1.

L'élément chauffant 13 est relié au connecteur électrique 12 par des moyens de conduction électrique sous forme de fils conducteurs 19. Dans l'exemple illustré dans la figure 5, l'une des extrémités de chaque fil conducteur 19 est soudée sur un patin respectif 20 dans la zone d'extrémité de la vertèbre 4, alors que son extrémité opposée est fixée au connecteur électrique 12.

La figure 6 montre schématiquement que les patins de contact 20 de la figure 5 sont noyés dans une résine 23 de manière à protéger les patins en assurant leur étanchéité.

Un autre objet de l'invention est un procédé d'assemblage d'un balai d'essuie-glace comportant le dispositif chauffant selon l'invention.

Le procédé d'assemblage selon l'invention comporte les phases suivantes :
- on dispose l'élément chauffant 13 le long d'une face inférieure de la vertèbre 4 et on fixe l'élément chauffant à la face inférieure;
- on insert la vertèbre 4 avec l'élément chauffant 13 dans un logement longitudinal 5 prévu sur l'élément de support 3, la longueur de celui-ci étant adaptée à celle de la vertèbre de sorte que les extrémités de celui-ci fassent saillie hors du logement 5 ;
- on fixe les moyens de conduction électrique 19 à l'une des extrémités de l'élément chauffant 13 pour relier celui-ci au connecteur électrique 12;
- on fait passer les moyens de conduction électrique 19 de la face inférieure à la face supérieure de la vertèbre en contournant l'extrémité de la vertèbre ;
- on positionne les moyens de conduction électrique 19 dans la fente longitudinale 17 de la face supérieure de l'élément de support 3 ouverte vers le haut (voir figure 7) et on fixe le connecteur électrique 12 à un connecteur mécanique 10 disposé sensiblement au milieu de l'élément de support 3 (voir figure 8);
- on fixe un élément de couverture 6 de part et d'autre du connecteur mécanique 10 ;
- on met en place une lame de raclage 2 dans une rainure de l'élément de support 3 ; et
- on fixe des capuchons d'embout 7 aux extrémités respectives de l'ensemble formé par l'élément de support 3, la vertèbre 4 et les éléments de couverture 6.

Selon une autre caractéristique du procédé selon l'invention, on fixe les moyens de conduction électrique 19 sur des patins de contact 20 prévus à ladite extrémité de l'élément chauffant.

Selon encore une autre caractéristique du procédé selon l'invention, on relie les moyens de conduction électrique 19 également au connecteur électrique 12 avant de les faire contourner l'une des extrémités de la vertèbre 4.

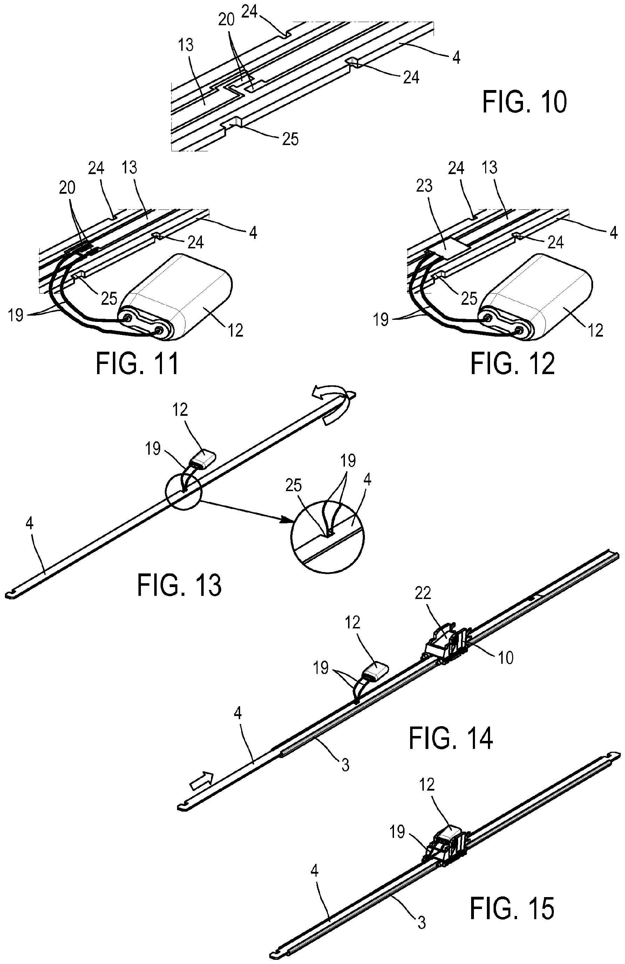

Les figures 10 à 15 montrent une mise en oeuvre du dispositif chauffant permettant de contourner la vertèbre 4 en faisant passer des fils conducteurs 19 par un de ses côtés latéraux, également pour éviter de faire des trous dans l'âme de celle-ci.

La figure 10 montre la partie centrale de la face inférieure d'une vertèbre 4 pourvue d'un élément chauffant 13 sous forme d'un film résistif adhéré sur cette face. La vertèbre comporte deux encoches centrales opposées 24 disposées sur les côtés latéraux de la vertèbre pour la fixation du connecteur mécanique 10. Elle est en outre pourvue d'une encoche latérale 25 qui est décalée dans le sens longitudinal par rapport au centre de l'élément de support 3 où est fixé le connecteur mécanique 10 de manière à se trouver juxtaposée à celui-ci lorsque la vertèbre 4 a été introduite par glissement dans le logement 5 de l'élément de support (voir figures 14 et 15).

L'encoche décalée 25 est suffisamment profonde pour d'une part recevoir les fils conducteurs 19 et pour d'autre part assurer que ceux-ci ne gênent pas l'introduction de la vertèbre 4 dans l'élément de support 3.

L'élément chauffant 13 est pourvu de patins de contact 20 qui dans ce cas sont disposés relativement près de l'encoche décalée 25.

L'une des extrémités des fils conducteurs 19 est avantageusement soudée sur un patin respectif 20 avant l'introduction par glissement de la vertèbre 4 dans le logement 5 de l'élément de support. L'autre extrémité des fils conducteurs 19 est déjà reliée au connecteur électrique 12. Le connecteur mécanique 10 est d'abord monté sur l'élément de support 3 et ensuite, la vertèbre 4 est insérée dans le logement 5, et le connecteur électrique 12 est mis en place dans le logement 22 prévu sur le connecteur mécanique 10, il ne reste qu'à assembler la lame de raclage 2, les deux éléments de couverture 6 et les capuchons 7, ainsi que la chape 14 qui vient coiffer le conducteur mécanique 10.

Un autre objet de l'invention est un balai d'essuie-glace comportant le dispositif chauffant selon l'invention. Ce balai d'essuie-glace fait avantageusement partie d'un dispositif d'essuyage utilisé sur un véhicule.

Bien entendu, l'invention n'est pas limitée aux exemples illustrés et décrits, et l'homme du métier sera en mesure de trouver des variantes sans pour autant sortir du cadre de l'invention, en particulier des variantes dans lesquelles des fils résistifs ou un revêtement résistif sont utilisés à la place du film résistif.

Il doit en particulier être noté que le balai d'essuie-glace à dispositif chauffant selon l'invention peut aussi être dépourvu de dispositif de distribution d'un liquide de lavage ou contrairement à cela être pourvu d'un double dispositif de distribution, un sur chaque côté latéral du balai. La présence d'un déflecteur aérodynamique n'est pas non plus indispensable pour la mise en oeuvre de l'invention.

## Revendications

1. Dispositif chauffant apte à être assemblé à un élément de support (3) d'un balai d'essuie-glace (1), le dispositif chauffant comportant :
• au moins un élément d'axe principal longitudinal (4) apte à être monté à l'intérieur d'un logement longitudinal (5) de l'élément de support (3) de manière à former une vertèbre, ledit logement (5) étant ouvert au-dessus de ladite vertèbre par une fente longitudinale (17) ;
• au moins un élément chauffant (13) disposé sur l'élément formant vertèbre (4) et relié par des moyens de conduction électrique (19) à un connecteur électrique (12) disposé sur une face dite supérieure de celui-ci ;
**caractérisé en ce que** l'élément chauffant (13) est disposé sur une face dite inférieure de l'élément formant vertèbre (4), et **en ce que** lesdits moyens de conduction électrique (19) passent de ladite face inférieure à ladite face supérieure en contournant l'élément formant vertèbre (4) à l'une des extrémités de celui-ci.

2. Dispositif chauffant selon la revendication 1, **caractérisé en ce que** lesdits moyens de conduction électrique (19) s'étendent le long de ladite fente (17), sur ladite face supérieure de l'élément formant vertèbre (4).

3. Dispositif chauffant selon la revendication 1 ou 2, **caractérisé en ce que** lesdits moyens de conduction électrique (19) sont reliés à l'élément chauffant (13) par l'intermédiaire de patins de contact (20) disposés dans une zone d'extrémité sur ladite face inférieure de l'élément formant vertèbre (4).

4. Dispositif chauffant selon la revendication 3, **caractérisé en ce que** ladite zone d'extrémité est centralement placée.

5. Dispositif chauffant selon la revendication 3 ou 4, **caractérisé en ce que** lesdits patins de contact (20) sont noyés dans une résine (23) assurant leur étanchéité.

6. Dispositif chauffant selon l'une quelconque des revendications précédentes, **caractérisé en ce que** l'élément chauffant est un film résistif fixé sur ladite face inférieure de l'élément formant vertèbre (4) et s'étendant jusqu'à proximité de l'extrémité de celui-ci à laquelle lesdits moyens de conduction électrique (19) le contournent.

7. Balai d'essuie-glace, **caractérisé en ce qu'**il comprend :
• un dispositif chauffant selon l'une quelconque des revendications 1 à 6;
• un élément de support (3) d'axe principal longitudinal qui comporte :
∘ un logement longitudinal ;
∘ des moyens de maintien d'une lame racleuse ;
• une lame racleuse ; et
• un connecteur mécanique (10) apte à relier le balai d'essuie-glace à un bras d'actionnement d'un dispositif d'essuyage, ce connecteur mécanique étant monté sur l'élément de support (3) dans lequel est inséré un élément formant vertèbre (4).

8. Procédé d'assemblage d'un balai d'essuie-glace selon la revendication 7, **caractérisé en ce qu'**il comporte les phases suivantes :
- on dispose un élément chauffant (13) le long d'une face inférieure d'un élément formant vertèbre (4) et on fixe l'élément chauffant à ladite face inférieure;
- on insert l'élément formant vertèbre (4) avec l'élément chauffant (13) dans un logement longitudinal (5) prévu sur un élément de support (3), la longueur de celui-ci étant adaptée à celle de l'élément formant vertèbre (4) de sorte que les extrémités de celui-ci fassent saillie hors dudit logement (5);
- on fixe des moyens de conduction électrique (19) à l'une des extrémités de l'élément chauffant (13) pour relier celui-ci à un connecteur électrique (12) ;
- on fait passer les moyens de conduction électrique (19) de ladite face inférieure à une face supérieure dudit élément formant vertèbre (4) en contournant ladite extrémité de l'élément formant vertèbre ;
- on positionne les moyens de conduction électrique (19) dans une fente longitudinale (17) de ladite face supérieure de l'élément de support (3) ouverte vers le haut et on fixe le connecteur électrique (12) à un connecteur mécanique (10) disposé sensiblement au milieu de l'élément de support (3);
- on fixe un élément de couverture (6) de part et d'autre du connecteur mécanique (10) ;
- on met en place une lame de raclage (2) dans une rainure de l'élément de support (3) ; et
- on fixe des capuchons d'embout (7) aux extrémités respectives de l'ensemble formé par l'élément de support (3), l'élément formant vertèbre (4) et les éléments de couverture (6).

9. Procédé selon la revendication 8, **caractérisé en ce qu'**on fixe les moyens de conduction électrique (19) sur des patins de contact (20) prévus à ladite extrémité de l'élément chauffant (13).

10. Procédé selon la revendication 8 ou 9, **caractérisé en ce qu'**on relie les moyens de conduction électrique (19) au connecteur électrique (12) avant de les faire contourner l'une des extrémités de l'élément formant vertèbre (4).

## Patentansprüche

1. Heizvorrichtung, die geeignet ist, mit einem Trägerelement (3) eines Scheibenwischerblatts (1) zusammengebaut zu werden, wobei die Heizvorrichtung umfasst:
• mindestens ein Element mit Hauptlängsachse (4), das geeignet ist, im Innern einer Längsaufnahme (5) des Trägerelements (3) so montiert zu werden, dass es ein Rückgrat bildet, wobei die Aufnahme (5) über dem Rückgrat mit einem Längsschlitz (17) offen ist;
• mindestens ein Heizelement (13), das auf dem rückgratbildenden Element (4) angeordnet ist und über elektrische Leitungsmittel (19) mit einem elektrischen Verbinder (12) verbunden ist, der auf seiner Oberseite angeordnet ist;
**dadurch gekennzeichnet, dass** das Heizelement (13) auf einer Unterseite des rückgratbildenden Elements (4) angeordnet ist und dass die elektrischen Leitungsmittel (19) von der Unterseite zur Oberseite verlaufen, wobei sie um eines der Enden des rückgratbildenden Elements (4) herumgeführt sind.

2. Heizelement nach Anspruch 1, **dadurch gekennzeichnet, dass** sich die elektrischen Leitungsmittel (19) entlang des Schlitzes (17) auf der Oberseite des rückgratbildenden Elements (4) erstrecken.

3. Heizvorrichtung nach Anspruch 1 oder 2, **dadurch gekennzeichnet, dass** die elektrischen Leitungsmittel (19) mit dem Heizelement (13) über Kontaktschuhe (20) verbunden sind, die in einem Endbereich auf der Unterseite des rückgratbildenden Elements (4) angeordnet sind.

4. Heizvorrichtung nach Anspruch 3, **dadurch gekennzeichnet, dass** der Endbereich mittig gelegen ist.

5. Heizvorrichtung nach Anspruch 3 oder 4, **dadurch gekennzeichnet, dass** die Kontaktschuhe (20) in ein Harz (23) eingebettet sind, das ihre Dichtheit gewährleistet.

6. Heizvorrichtung nach einem der vorhergehenden Ansprüche, **dadurch gekennzeichnet, dass** das Heizelement eine Widerstandsfolie ist, die auf der Unterseite des rückgratbildenden Elements (4) befestigt ist und sich bis in die Nähe von dessen Ende erstrecken, um das die elektrischen Leitungsmittel (19) herumgeführt sind.

7. Scheibenwischerblatt, **dadurch gekennzeichnet, dass** es umfasst:
• eine Heizvorrichtung nach einem der Ansprüche 1 bis 6;
• ein Trägerelement (3) mit Hauptlängsachse, das aufweist:
∘ eine Längsaufnahme;
∘ Haltemittel für ein Wischergummi;
• ein Wischergummi; und
• einen mechanischen Verbinder (10), der geeignet ist, das Scheibenwischerblatt mit einem Betätigungsarm einer Wischvorrichtung zu verbinden, wobei dieser mechanische Verbinder auf dem Trägerelement (3) montiert ist, in das ein rückgratbildendes Element (4) eingesetzt ist.

8. Verfahren zum Zusammenbauen eines Scheibenwischerblatts nach Anspruch 7, **dadurch gekennzeichnet, dass** es die folgenden Phasen umfasst:
- ein Heizelement (13) wird entlang einer Unterseite eines rückgratbildenden Elements (4) angeordnet und das Heizelement an der Unterseite befestigt;
- das rückgratbildende Element (4) mit dem Heizelement (13) wird in eine Längsaufnahme (5) eingesetzt, die an einem Trägerelement (3) vorgesehen ist, wobei dessen Länge an die des rückgratbildenden Elements (4) so angepasst ist, dass dessen Enden über die Aufnahme überstehen (5);
- elektrische Leitungsmittel (19) werden an einem der Enden des Heizelements (13) befestigt, um dieses mit einem elektrischen Verbinder (12) zu verbinden;
- die elektrischen Leitungsmittel (19) werden von der Unterseite zu einer Oberseite des rückgratbildenden Elements (4) geführt, wobei sie um das Ende des rückgratbildenden Elements herumgeführt werden;
- die elektrischen Leitungsmittel (19) werden in einem Längsschlitz (17) der Oberseite des Trägerelements (3) positioniert, der nach oben offen ist, und der elektrische Verbinder (12) wird an einem mechanischen Verbinder (10) befestigt, der im Wesentlichen in der Mitte des Trägerelements (3) angeordnet ist;
- ein Abdeckelement (6) wird beidseits des mechanischen Verbinders (10) befestigt;
- ein Wischergummi (2) wird in einen Kanal des Trägerelements (3) eingeführt; und
- Endkappen (7) werden an den jeweiligen Enden der aus dem Trägerelement (3), dem rückgratbildenden Element (4) und den Abdeckelementen (6) gebildeten Anordnung befestigt.

9. Verfahren nach Anspruch 8, **dadurch gekennzeichnet, dass** die elektrischen Leitungsmittel (19) an Kontaktschuhen (20) befestigt werden, die an dem Ende des Heizelements (13) vorgesehen sind.

10. Verfahren nach Anspruch 8 oder 9, **dadurch gekennzeichnet, dass** die elektrischen Leitungsmittel (19) mit dem elektrischen Verbinder (12) verbunden werden, bevor sie um eines der Enden des rückgratbildenden Elements (4) herumgeführt werden.

## Claims

1. Heating device adapted to be assembled to a support element (3) of a windscreen wiper (1), the heating device including:
• at least one element (4) having a longitudinal main axis and adapted to be mounted inside a longitudinal housing (5) of the support element (3) so as to form a spline, said housing (5) being open above said spline via a longitudinal slot (17);
• at least one heating element (13) disposed on the element (4) forming a spline and connected by electrically conductive means (19) to an electrical connector (12) disposed on a so-called upper face thereof;
**characterized in that** the heating element (13) is disposed on a so-called lower face of the element (4) forming a spline and **in that** said electrically conductive means (19) pass from said lower face to said upper face around the element (4) forming a spline at one of the ends thereof.

2. Heating device according to Claim 1, **characterized in that** said electrically conductive means (19) extend along said slot (17) on said upper face of the element (4) forming a spline.

3. Heating device according to Claim 1 or 2, **characterized in that** said electrically conductive means (19) are connected to the heating element (13) via contact shoes (20) disposed in an end zone on said lower face of the element (4) forming a spline.

4. Heating device according to Claim 3, **characterized in that** said end zone is centrally placed.

5. Heating device according to Claim 3 or 4, **characterized in that** said contact shoes (20) are buried in a resin (23) for sealing them.

6. Heating device according to any one of the preceding claims, **characterized in that** the heating element is a resistive film fixed to said lower face of the element (4) forming a spline and extending to the vicinity of the end thereof at which said electrically conductive means (19) pass round it.

7. Windscreen wiper, **characterized in that** it includes:
• a heating device according to any one of Claims 1 to 6;
• a support element (3) having a longitudinal main axis that includes:
∘ a longitudinal housing;
∘ means for retaining a wiper blade;
• a wiper blade; and
• a mechanical connector (10) adapted to connect the windscreen wiper to an actuating arm of a wiping device, this mechanical connector being mounted on the support element (3) into which is inserted an element (4) forming a spline.

8. Method of assembling a windscreen wiper according to Claim 7, **characterized in that** it includes the following phases:
- a heating element (13) is disposed along a lower face of an element (4) forming a spline and the heating element is fixed to said lower face;
- the element (4) forming a spline is inserted with the heating element (13) into a longitudinal housing (5) provided on a support element (3), the length of the latter being matched to that of the element (4) forming a spline so that the ends of the latter project out of said housing (5);
- electrically conductive means (19) are fixed to one of the ends of the heating element (13) to connect the latter to an electrical connector (12);
- the electrically conductive means (19) are passed from said lower face to an upper face of said element (4) forming a spline around said end of the element forming a spline;
- the electrically conductive means (19) are positioned in a longitudinal slot (17) of said upper face of the support element (3) open upwardly and the electrical connector (12) is switched to a mechanical connector (10) disposed substantially in the middle of the support element (3);
- a cover element (6) is fixed on either side of the mechanical connector (10);
- a wiper blade (2) is placed in a groove of the support element (3); and
- end caps (7) are fixed to respective ends of the assembly formed by the support element (3), the element (4) forming a spline and the cover elements (6).

9. Method according to Claim 8, **characterized in that** the electrically conductive means (19) are fixed to contact shoes (20) provided at said end of the heating element (13).

10. Method according to Claim 8 or 9, **characterized in that** the electrically conductive means (19) are connected to the electrical connector (12) before passing them around one of the ends of the element (4) forming a spline.
